# EUROPÄISCHE PATENTSCHRIFT

(11) **EP 1 644 559 B1**
(45) Veröffentlichungstag und Bekanntmachung des Hinweises auf die Patenterteilung: **28.08.2013**
(21) Anmeldenummer: 04737372.5
(22) Anmeldetag: 07.07.2004
(51) Int. Cl.: D01D 4/02, H01J 37/00

(54) **VERFAHREN ZUR HERSTELLUNG POLYMERER FORMKÖRPER**
METHOD FOR THE PRODUCTION OF POLYMER MOULDED BODIES
PROCEDE DE PRODUCTION DE CORPS POLYMERES FACONNES

(30) Priorität: 14.07.2003 AT 10822003
(43) Veröffentlichungstag der Anmeldung: 12.04.2006
(73) Patentinhaber: LENZING AKTIENGESELLSCHAFT, 4860 Lenzing (AT)
(72) Erfinder: FEILMAIR, Wilhelm, A-4863 Seewalchen (AT); SCHREMPF, Christoph, A-4701 Bad Schallerbach (AT); HAINBUCHER, Karl, Michael, A-4840 Vöcklabruck (AT); FUCHS, Helmut, A-4890 Frankenmarkt (AT)
(74) Vertreter: Nemec, Harald
(86) Internationale Anmeldenummer: PCT/AT2004/000242
(87) Internationale Veröffentlichungsnummer: WO 2005/005695

(56) Entgegenhaltungen:
- EP-A- 0 756 025
- DE-B- 1 034 786
- DE-B- 1 100 835
- US-A- 2 844 706
- US-A- 4 705 605

## Beschreibung

Die Erfindung betrifft ein Verfahren zur Herstellung cellulosischer Formkörper, bei dem eine Celluloselösung in einem wässrigen tertiären Aminoxid über ein Formwerkzeug, welches ein Trägermaterial und zumindest eine im Trägermaterial angeordnete Extrusionsöffnung aufweist, extrudiert und aus der extrudierten, geformten Masse auf an sich bekannte Weise durch Ausfällen der cellulosische Formkörper erhalten wird.

Insbesondere betrifft die Erfindung ein Verfahren zur Herstellung von Cellulosefasern, bei welchem also das Formwerkzeug eine Spinndüse mit Extrusionsöffnungen in Form von Spinnlöchern ist.

Zur Herstellung von cellulosischen Formkörpern werden üblicherweise Formwerkzeuge eingesetzt, deren Extrusionsöffnungen mechanisch durch Materialverdrängung gefertigt werden.

Im Fall von Spinndüsen wird mit einem Stechwerkzeug das Spinnloch gestochen. Dieser Vorgang besteht zumeist aus mehreren Schritten. Einer der Gründe dafür ist, daß die üblicherweise zur Verwendung kommenden Materialien auf Grund der vorliegenden hohen Spinndrücke eine gewisse Mindestdicke aufweisen müssen. Ab einer gewissen Dicke des Materials kann aber das Loch nicht mehr in einem einzigen Stechvorgang gestochen werden. Weiters entstehen durch die Materialverdrängung beim Stechvorgang unerwünschte Anhäufungen an verdrängtem Material. Daher sind zum Teil aufwendige Nachbearbeitungsschritte notwendig. Die Dicke von Spinndüsen bewegt sich im Bereich von ca. 300 µm bis zu mehreren Millimetern.

Als Düsenmaterialien werden beispielsweise Gold/Platin-Legierungen, weiche Stähle oder Keramiken eingesetzt. Im allgemeinen müssen Materialien ausgewählt werden, welche eine hinreichende Duktilität und Weichheit aufweisen, um beim mechanischen Formen der Löcher dem Materialverdrängungsprozeß standzuhalten. Dadurch wird die Festigkeit der eingesetzten Materialien limitiert. Da beim Spinnprozeß wie erwähnt hohe Spinndrücke auftreten können, ist damit die Größe der Spinndüse und dadurch auch die Produktivität limitiert.

Eine mechanische Fertigung der Spinnlöcher erlaubt eine hohe Präzision bei der Reproduzierbarkeit der Form der Löcher. Weiters kann über die Form der Fertigungswerkzeuge die Düsenlochform bestimmt werden. Dies betrifft z.B. den Verlauf des Düsenlochradius über die Düsenlochlänge oder allgemein die Querschnittsform des Düsenloches an sich. Der gravierende Nachteil dieser Fertigungsmethoden liegt in den damit verbundenen enorm hohen Fertigungskosten.

Düsenmaterialien, die im Lyocellverfahren zum Einsatz kommen, werden z.B. in der PCT-WO 94/28211 oder in der EP 0 430 926 beschrieben. Ein solches Verfahren ist ebenfalls in der EP 0 726 025 A2 beschrieben. In der DE 10 34 736 wird ein Verfahren zum Herstellen von Spinndüsen offenbart.

Die vorliegende Erfindung stellt sich die Aufgabe, ein Verfahren zur Herstellung von cellulosischen Formkörpern zur Verfügung zu stellen, bei welchem ein Formwerkzeug zum Einsatz kommt, dessen Extrusionsöffnungen mit geringem Aufwand hergestellt werden können, sich aber trotzdem zur Herstellung qualitativ hochstehender Formkörper eignen.

Diese Aufgabe wird gemäß einem Aspekt der Erfindung mit einem Verfahren zur Herstellung cellulosischer Formkörper, bei dem eine Celluloselösung in einem wässrigen tertiären Aminoxid über ein Formwerkzeug, welches ein Trägermaterial und zumindest eine im Trägermaterial angeordnete Extrusionsöffnung aufweist, extrudiert und aus der extrudierten, geformten Masse auf an sich bekannte Weise durch Ausfällen der cellulosische Formkörper erhalten wird, gelöst, welches dadurch gekennzeichnet ist, daß die formbare Masse über ein Formwerkzeug extrudiert wird, bei welchem zumindest eine Extrusionsöffnung durch Aufbringen thermischer Energie mittels Elektronenstrahlen hergestellt wurde.

Das Verfahren, in welchem eine formbare Masse eine Celluloselösung in einem wässrigen tertiären Aminoxid zu Formkörpern extrudiert wird, ist als "Aminoxidverfahren" bzw. "Lyocellverfahren" bekannt. Die Celluloselösung wird dabei bevorzugt nach der Extrusion über einen Luftspalt in ein Fällbad geführt. Mit diesem Verfahren hergestellte Cellulosefasern haben den Gattungsnamen "Lyocell".

Das Formwerkzeug ist bevorzugt eine Spinndüse mit Extrusionsöffnungen in Form eines oder mehrerer Spinnlöcher.

Es wird somit alternativ zur Verwendung von mechanisch gefertigten Extrusionsöffnungen, insbesondere Spinndüsenlöchern, vorgeschlagen, mittels Elektronenstrahlen gefertigte Löcher zu verwenden.

Der Einsatz von Elektronenstrahlen zur Fertigung von Sieben u.ä. ist bekannt. Bei diesen Anwendungszwecken werden aber eher geringere Anforderungen an die Form und den Grad der Reproduzierbarkeit der Löcher gesetzt.

Ein Maß für die Fertigungsgenauigkeit von Spinndüsenlöchern ist die Streuung der Düsenlochausgangsdurchmesser bei z.B. runden Spinnlöchern. Dies ist deshalb ein wichtiger Wert, da der Lochdurchmesser die pro Zeiteinheit durch das Loch geförderte Spinnlösungsmenge und damit die Feinheit der erhaltenen Spinnfäden mitbestimmt. Je stärker die Lochdurchmesser (insbesondere die Ausgangsdurchmesser) innerhalb einer Spinndüse streuen, umso größer wird die Streuung der Faserfeinheit und umso unsicherer wird auch das Spinnverhalten (z.B. das Auftreten von Filamentbrüchen im Luftspalt).

Es wurde nun gefunden, daß die Streuung der Durchmesser der Düsenlochausgänge von Spinndüsen, deren Spinnlöcher mit Elektronenstrahlen hergestellt wurden, größer ist als bei herkömmlichen Spinndüsen. So liegen typische Streuungswerte des Durchmesseres des Düsenlochausgangs bei mechanisch hergestellten Spinndüsen in einem Bereich von deutlich unter 5%, während dieser Wert bei mit Elektronenstrahlen hergestellten Löchern bei deutlich über 5% bis zu 15% liegt.

Überraschenderweise spiegelt sich diese Tatsache in der Streuung der Feinheiten der Spinnfäden (Titer) aber nicht wieder. Vergleichsmessungen ergaben gleich gute, teilweise sogar bessere Verteilungswerte des Titers. Auch die Spinnstabilität wurde überraschenderweise nicht durch die größere Streuung des Durchmessers des Düsenlochausgangs (der durch die Fläche des Loches ausgedrückt wird) negativ beeinflußt.

Bisher bekannte Formen von Düsenlöchern zur Verspinnung von Polymeren, insbesondere von Cellulosefasern nach dem Lyocellverfahren, können komplexe Abfolgen von zylindrischen und konischen Abschnitten aufweisen. Es wird damit versucht, eine trichterartige Form nachzustellen. Damit möchte man ein möglichst günstiges Strömungsverhalten innerhalb des Düsenloches und damit ein optimales Spinnverhalten erreichen.

Ein mittels Elektronenstrahlen geformtes Loch weist aber an sich (ohne daß in separaten Schritten verschiedene zylindrische oder konische Abschnitte hergestellt werden müßten) eine im wesentlichen trichterartige Form auf und kommt daher diesem Ideal sehr nahe.

Dadurch wird der mittlere Durchmesser des Querschnitts des durch das Spinnloch extrudierten Stromes der formbaren Masse stetig verringert.

Weiters weisen Spinnlöcher, die mittels Elektronenstrahlen hergestellt wurden, wie Untersuchungen an Einzellöchern belegen, eine äußerst glatte und homogene Oberfläche auf, was für den Durchtritt der Spinnlösung von Vorteil ist.

Außerdem sind bei einem mittels Elektronenstrahlen hergestellten Spinnloch die Kanten am Lochausgang bzw. Locheingang abgerundet, während bei mechanisch hergestellten Spinnlöchern die Kanten scharf sind.

Es ist daher festzustellen, daß sich Formwerkzeuge, deren Extrusionsöffnungen mittels Elektronenstrahlen hergestellt wurden, bei gleichzeitig vergleichsweise günstiger Fertigung hervorragend zur Herstellung von cellulosischen Formkörpern eignen. Da keine Verdrängung des Materials stattfinden muß, erweitert sich die Palette der einsetzbaren Materialien dramatisch. Zum Beispiel können hochfeste Stähle eingesetzt werden, welche es dann erlauben, die Größe der Formwerkzeuge, insbesondere der Spinndüsen, und damit die Produktivität von Produktionseinheiten zu steigern. Weiters kann bei Spinndüsen, da keine Verdrängung des Materials stattfinden muß, die Lochdichte erheblich erhöht werden.

Darüberhinaus hat sich herausgestellt, daß es möglich ist, mittels Elektronenstrahlen Spinnlöcher mit geringem Durchmesser von z.B. 100 µm oder weniger auch in vergleichsweise dicken Blechen mit Stärken von bis zu 4 bis 5 mm herzustellen.

Das Verhältnis von Länge der Düse L zu Durchmesser des Ausgangsloches D beträgt bevorzugt L/D < 50, besonders bevorzugt L/D < 30, am meisten bevorzugt L/D < 20.

In der bevorzugten Ausführungsform des erfindungsgemäßen Verfahrens, bei welcher das Formwerkzeug eine Spinndüse mit Extrusionsöffnungen in Form von Spinnlöchern ist, ist das Trägermaterial bevorzugt ringförmig ausgestaltet. Ein ringförmiger Aufbau einer Spinndüse ist z.B. aus der PCT-WO 95/04173 bekannt.

Alternativ dazu kann das Trägermaterial in Form eines Viereckes, insbesondere in Form eines Rechteckes, ausgestaltet sein. Spinndüsen in rechteckiger Form sind z.B. aus der PCT-WO 94/28218 bekannt.

Das Trägermaterial kann in Form eines Plättchens ausgestaltet sein, in dem die Spinnlöcher ausgeführt sind, und wobei das Plättchen in Löchern, insbesondere Stufenbohrungen, einer Trägerplatte eingesetzt ist, wie an sich aus der EP 0 430 926 A2 bekannt.

Das Trägermaterial kann in Form eines tiefgezogenen Spinneinsatzes ausgebildet sein.

Das Trägermaterial kann auch mit einem Düsenkörper plan und in diesen eingeschweißt sein, wie aus der bereits zitierten PCT-WO 94/28218 bekannt.

In der Spinndüse sind bevorzugt mehr als 1000, besonders bevorzugt mehr als 10000 Spinnlöcher vorgesehen. Der Durchmesser des Lochaustrittes der Spinnlöcher liegt bevorzugt in einem Bereich von 50 µm bis 1000 µm, besonders bevorzugt von 100 µm bis 500 µm.

Die Celluloselösung weist bevorzugt eine Nullviskosität von zumindest 100 Pas bei 90°C auf. Solche formbare Massen können hervorragend durch elektronenstrahlgefertigte Extrusionsöffnungen extrudiert werden.

Dem Fachmann sind Verfahren zur Herstellung von Bohrungen in Materialien wie z.B. Blechen mittels Elektronenstrahlen bekannt. Entsprechende Verfahren werden z.B. von den Firmen Pro-Beam KgaA und Acceleron Inc. durchgeführt.

### Figuren:

Die Figur 1 zeigt eine mikroskopische Aufnahme des Längsschnittes eines erfindungsgemäß mittels Elektronenstrahlen hergestellten Spinnloches.

Die Figur 2 zeigt eine mikroskopische Aufnahme des Längsschnittes eines herkömmlich mechanisch hergestellten Spinnloches.

Zur Herstellung dieser Aufnahmen wurden die Spinnlöcher jeweils mit einem Füllmaterial gefüllt und dieses Füllmaterial anschließend aus den Löchern herausgezogen. Das entsprechend dem Innenprofil der Löcher geformte Füllmaterial wurde dann unter dem Mikroskop fotografiert.

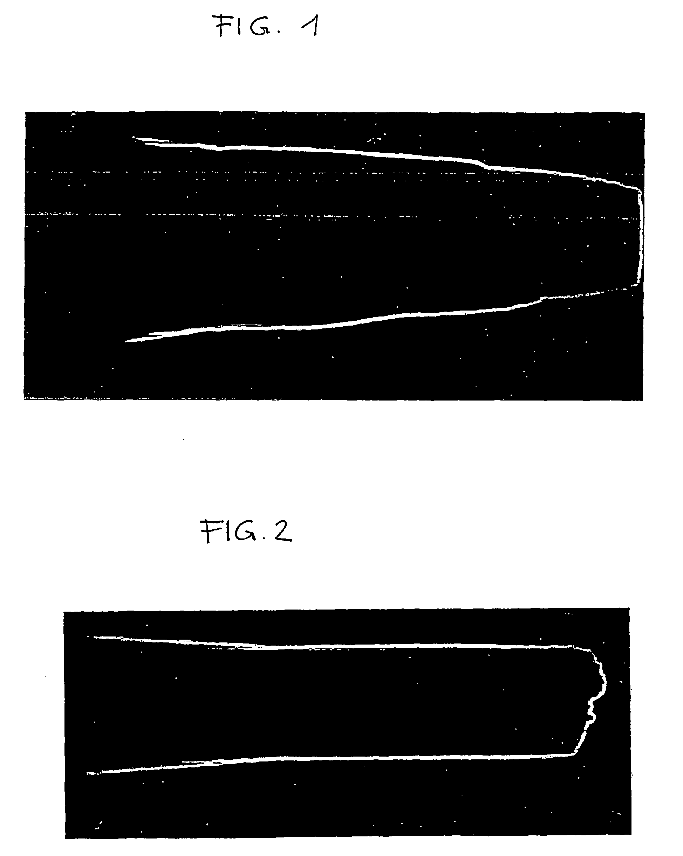

Beim Vergleich der beiden Figuren fällt beim mittels Elektronenstrahlen gebohrten Spinnloch (Figur 1) der über die gesamte Länge im wesentlichen trichterförmige Verlauf auf, während bei der Figur 2 deutlich zwei verschiedene Bereiche, nämlich ein konusartiger erster Bereich und ein im wesentlichen zylindrischer zweiter Bereich zu sehen sind.

Weiters ist in der Figur 1 deutlich der im Vergleich zur Figur 2 unregelmäßigere Längsverlauf der Lochwandung zu sehen.

### Beispiele:

### Beispiel 1:

Es werden zwei Spinndüsen mit jeweils ca. 47.500 Spinnlöchern, deren Durchmesser mit jeweils 100 µm spezifiziert war, miteinander verglichen, wobei die Spinnlöcher der einen Spinndüse mittels Elektronenstrahlen hergestellt wurden und die Spinnlöcher der anderen Düse herkömmlich mechanisch gestochen worden waren.

Die Spinndüsen waren, wie in der PCT-WO 95/04173 beschrieben, als Ringdüsen ausgestaltet. Das ringförmige Trägermaterial bestand aus Edelstahl.

In der folgenden Tabelle 1 sind die Daten der verwendeten Spinndüsen näher angegeben:

**Tabelle 1**

| Spinndüse (Fertigungsmethode) | Stahlqualität | Blechdicke des Trägermaterials (mm) | Festigkeit des Stahls (N/mm²) |
|---|---|---|---|
| Stand der Technik (mechanisch gestochene Löcher) | 1.4016 | 1,0 | 450-600 |
| Erfindungsgemäß (mittels Elektronenstrahlen hergestellte Löcher) | 1.4310 | 0,5 | 1.600 bis 1.800 |

Im folgenden werden zunächst die Eigenschaften der Spinnlöcher der beiden verwendeten Düsen miteinander verglichen. Dabei wurden mittels an sich bekannter Bildverarbeitungsmethoden die Fläche F und der jeweils maximale Durchmesser Dₘₐₓ der Austrittsöffnungen von mehreren Spinnlöchern ermittelt und daraus der Mittelwert gebildet. Aus der Fläche wurde der theoretische Durchmesser D_{theor.} der Austrittsöffnung (d.h. unter der Annahme, daß die Austrittsöffnung kreisrund sei) berechnet. Das Verhältnis von gemessenem maximalem Durchmesser zu aus der Fläche berechnetem theoretischen Durchmesser ergibt ein Maß für die Abweichung der Austrittsöffnung vom Ideal einer kreisrunden Öffnung. Weiters wurde die Streuung der gemessenen Flächen, der Dₘₐₓ und der D_{theor.} bestimmt, und es wurden die jeweils kleinsten gemessenen bzw. berechneten Werte den jeweils größten gemessenen bzw. berechneten Werte gegenübergestellt.

In der folgenden Tabelle 2 sind die Ergebnisse dieser Messungen bzw. Berechnungen aufgelistet:

**Tabelle 2**

| | Düse mit mittels Elektronenstrahlen hergestellten Spinnlöchern | | | Düse mit herkömmlich (mechanisch) hergestellten Spinnlöchern | | |
|---|---|---|---|---|---|---|
| | Fläche F (µm²) | dₘₐₓ(µm) | d_{theor.} (µm) | Fläche F (µm²) | dₘₐₓ (µm) | d_{theor.} (µm) |
| Mittelwert aus den Messungen | 7138 | 100 | 95 | 8591 | 108 | 105 |
| Standardabweichung Cᵥ (%) | 8 | 5 | 4 | 3 | 2 | 2 |
| Minimalwert | 5942 | 90 | 87 | 7814 | 104 | 100 |
| Maximalwert | 8331 | 109 | 103 | 8974 | 111 | 107 |

Aus der Tabelle 2 ergibt sich, daß die mittels Elektronenstrahlen hergestellten Spinnlöcher sowohl hinsichtlich der Rundheit als auch hinsichtlich ihrer Fläche bei weitem ungleichmäßiger sind als die herkömmlich mechanisch hergestellten Löcher. Insbesondere ist eine deutlich größere Streuung der Austrittsflächen F (von 5942 µm² bis 8331 µm²) der mittels Elektronenstrahlen hergestellten Spinnlöcher festzustellen.

Eine gemäß dem in der EP 0 356 419 beschriebenen Verfahren hergestellte Lösung der Cellulose in einem tertiären Aminoxid wurde nun jeweils durch die beiden oben beschriebenen Spinndüsen extrudiert. Die extrudierten Filamente wurden gemäß dem in der PCT-WO 93/19230 beschriebenen Verfahren über einen Luftspalt in ein Fällbad geführt und in an sich bekannter Weise zu Cellulosefasern weiterverarbeitet.

Dabei war zunächst zu beobachten, daß das Spinnverhalten (d.h. das Auftreten von Filamentbrüchen oder sonstigen Spinnstörungen) beim Extrudieren über die Spinndüse mit mittels Elektronenstrahlen hergestellten Spinnlöchern gleich gut war wie das Spinnverhalten bei der Spinndüse nach dem Stand der Technik.

An einem repräsentativen Querschnitt der hergestellten Fasern wurde der Titer gemessen und daraus der Mittelwert und die Standardabweichung Cᵥ ermittelt sowie der maximal und der minimal aufgefunde Titer notiert.

Die Ergebnisse sind in der folgenden Tabelle 3 aufgelistet:

**Tabelle 3**

| | Düse mit mittels Elektronenstrahlen hergestellten Spinnlöchern | Düse mit herkömmlich (mechanisch) hergestellten Spinnlöchern |
|---|---|---|
| Titer (Mittelwert) | 1,34 dtex | 1,20 dtex |
| Titer (Mindestwert) | 0,94 dtex | 0,77 dtex |
| Titer (Maximalwert) | 1,66 dtex | 1,55 dtex |
| Standardabweichung Cᵥ (%) | 11,4 | 11,4 |

Aus der Tabelle 3 ist ersichtlich, daß die beiden getesteten Spinndüsen praktisch gleich gute Ergebnisse hinsichtlich der erhaltenen Titerverteilung erzielen; dies obwohl die mittels Elektronenstrahlen hergestellten Spinnlöcher ungleichmäßigere Abmessungen hatten als die mechanisch gestochenen Spinnlöcher.

### Beispiel 2:

Es werden zwei Spinndüsen mit jeweils ca. 25.000 Spinnlöchern, deren Durchmesser mit jeweils 160 µm spezifiziert war, miteinander verglichen, wobei die Spinnlöcher der einen Spinndüse mittels Elektronenstrahlen hergestellt wurden und die Spinnlöcher der anderen Düse herkömmlich mechanisch gestochen worden waren.

Die Spinndüsen waren wiederum, wie in der PCT-WO 05/04173 beschrieben, als Ringdüsen ausgestaltet. Das ringförmige Trägermaterial bestand aus Edelstahl.

In der folgenden Tabelle 4 sind die Daten der verwendeten Spinndüsen näher angegeben:

**Tabelle 4**

| Spinndüse (Fertigungsmethode) | Stahlqualität | Blechdicke des Trägermaterials (mm) | Festigkeit des Stahls (N/mm²) |
|---|---|---|---|
| Stand der Technik (mechanisch gestochene Löcher) | 1.4016 | 0,8 | 450-600 |
| Erfindungsgemäß (mittels Elektronenstrahlen hergestellte Löcher) | 1.4310 | 0,8 | 1.600 bis 1.800 |

Im folgenden wurden wie im Beispiel 1 die Abmessungen der Austrittsöffnungen der Spinnlöcher miteinander verglichen.

In der folgenden Tabelle 5 sind die Ergebnisse dieser Messungen bzw. Berechnungen aufgelistet:

**Tabelle 5**

| | Düse mit mittels Elektronenstrahlen hergestellten Spinnlöchern | | | Düse mit herkömmlich (mechanisch) hergestellten Spinnlöchern | | |
|---|---|---|---|---|---|---|
| | Fläche F (µm²) | dₘₐₓ (µm) | d_{theor.} (µm) | Fläche F (µm²) | dₘₐₓ (µm) | d_{theor.} (µm) |
| Mittelwert aus den Messungen | 18993 | 159 | 155 | 21193 | 166 | 164 |

| | Fläche F (µm²) | dₘₐₓ(µm) | d_{theor.} (µm) | Fläche F (µm²) | dₘₐₓ(µm) | d_{theor.} (µm) |
|---|---|---|---|---|---|---|
| Standardabweichung Cᵥ (%) | 13,6 | 7,2 | 7,3 | 1,7 | 1,0 | 0,8 |
| Minimalwert | 7325 | 105 | 97 | 20532 | 163 | 162 |
| Maximalwert | 29620 | 200 | 194 | 21910 | 170 | 167 |

Aus der Tabelle 5 ergibt sich wiederum, daß die mittels Elektronenstrahlen hergestellten Spinnlöcher sowohl hinsichtlich der Rundheit als auch hinsichtlich ihrer Fläche bei weitem ungleichmäßiger sind als die herkömmlich mechanisch hergestellten Löcher.

Es wurden nunmehr wie im Beispiel 1 lösungsmittelgesponnene Cellulosefasern unter Verwendung dieser Spinndüsen hergestellt und die Titerverteilung gemessen.

Dabei war wieder zu beobachten, daß das Spinnverhalten beim Extrudieren über die Spinndüse mit mittels Elektronenstrahlen hergestellten Spinnlöchern gleich gut war wie das Spinnverhalten bei der Spinndüse nach dem Stand der Technik.

Die Ergebnisse hinsichtlich der Titerverteilung sind in der folgenden Tabelle 6 aufgelistet:

**Tabelle 6**

| | Düse mit mittels Elektronenstrahlen hergestellten Spinnlöchern | Düse mit herkömmlich (mechanisch) hergestellten Spinnlöchern |
|---|---|---|
| Titer (Mittelwert) | 6,6 dtex | 6,6 dtex |
| Titer (Mindestwert) | 4,6 dtex | 4,8 dtex |
| Titer (Maximalwert) | 7,9 dtex | 10,7 dtex |
| Standardabweichung Cᵥ(%) | 9,6 % | 18,2 % |

Aus der Tabelle 6 ist ersichtlich, daß in diesem Fall mit der erfindungsgemäß verwendeten Spinndüse eine deutlich bessere Titerverteilung (geringere Standardabweichung) erzielt werden konnte.

Die erfindungsgemäßen Spinndüsen gemäß Beispiel 1 und Beispiel 2 können kostengünstiger hergestellt werden als die jeweils zum Vergleich herangezogenen Spinndüsen mit mechanischer Herstellung der Spinnlöcher. Zudem weisen die erfindungsgemäßen Spinndüsen gemäß Tabelle 1 und Tabelle 4 eine deutliche höhere Festigkeit auf und können daher höheren Produktionsdrücken standhalten. Es ist daher möglich, die Produktivität des Verfahrens mit den erfindungsgemäßen Spinndüsen erheblich zu steigern.

## Patentansprüche

1. Verfahren zur Herstellung cellulosischer Formkörper, bei dem eine Celluloselösung in einem wässrigen tertiären Aminoxid über ein Formwerkzeug, welches ein Trägermaterial und zumindest eine im Trägermaterial angeordnete Extrusionsöffnung aufweist, extrudiert und aus der extrudierten, geformten Masse auf an sich bekannte Weise durch Ausfällen der cellulosische Formkörper erhalten wird, **dadurch gekennzeichnet, daß** die formbare Masse über ein Formwerkzeug extrudiert wird, bei welchem zumindest eine Extrusionsöffnung durch Aufbringen thermischer Energie mittels Elektronenstrahlen hergestellt wurde.

2. Verfahren gemäß Anspruch 1, **gekennzeichnet durch** die Verwendung einer Spinndüse mit Extrusionsöffnungen in Form eines oder mehrerer Spinnlöcher als Formwerkzeug.

3. Verfahren gemäß Anspruch 2, **dadurch gekennzeichnet, daß** der mittlere Durchmesser des Querschnitts des durch das Spinnloch extrudierten Stromes der formbaren Masse stetig verringert wird.

4. Verfahren gemäß Anspruch 2 oder 3, **gekennzeichnet durch** die Verwendung eines ringförmig ausgestalteten Trägermaterials.

5. Verfahren gemäß Anspruch 2 oder 3, **gekennzeichnet durch** die Verwendung eines in Form eines Vierecks, insbesondere in Form eines Rechteckes, ausgestalteten Trägermaterials.

6. Verfahren gemäß einem der Ansprüche 2 bis 5, **gekennzeichnet durch** die Verwendung eines Trägermaterials, welches in Form eines Plättchen ausgestaltet ist, in dem die Spinnlöcher ausgeführt sind, und wobei das Plättchen in Löchern, insbesondere Stufenbohrungen einer Trägerplatte, eingesetzt ist.

7. Verfahren gemäß einem der Ansprüche 2 bis 5, **gekennzeichnet durch** die Verwendung eines in Form eines tiefgezogenen Spinneinsatzes ausgebildeten Trägermaterials.

8. Verfahren gemäß einem der Ansprüche 2 bis 5, **gekennzeichnet durch** die Verwendung eines Trägermaterials, welches mit einem Düsenkörper plan und in diesen eingeschweißt ist.

9. Verfahren gemäß einem der Ansprüche 2 bis 8, **gekennzeichnet durch** die Verwendung einer Spinndüse, in der mehr als 1000, bevorzugt mehr als 10000, Spinnlöcher vorgesehen sind.

10. Verfahren gemäß einem der Ansprüche 2 bis 9, **gekennzeichnet durch** die Verwendung von Spinnlöchern, bei welchen der Durchmesser des Lochaustrittes in einem Bereich von 50 um bis 1000 µm, bevorzugt von 100 µm bis 500 µm, liegt.

11. Verfahren gemäß einem der vorhergehenden Ansprüche, **dadurch gekennzeichnet, daß** die Celluloselösung eine Nullviskosität von zumindest 100 Pas bei 90°C aufweist.

12. Verfahren gemäß einem der vorhergehenden Ansprüche, **dadurch gekennzeichnet, daß** die Celluloselösung nach der Extrusion über einen Luftspalt in ein Fällbad geführt wird.

## Claims

1. A process for the production of cellulosic moulded bodies, wherein a cellulose solution is extruded in an aqueous tertiary amine oxide via a forming tool comprising a carrier material and at least one extrusion orifice arranged in the carrier material and is obtained from the extruded moulded mass in a manner known per se by precipitating the cellulosic moulded bodies, **characterized in that** the mouldable mass is extruded via a forming tool on which at least one extrusion orifice was produced by the application of thermal energy by means of electron rays.

2. A process according to claim 1, **characterized by** the use of a spinneret comprising extrusion orifices in the shape of one or several spinning holes as a forming tool.

3. A process according to claim 2, **characterized in that** the mean diameter of the cross-section of the flow of mouldable mass extruded through the spinning hole is continuously decreased.

4. A process according to claim 2 or 3, **characterized by** the use of a carrier material configured in the shape of a ring.

5. A process according to claim 2 or 3, **characterized by** the use of a carrier material configured in the shape of a square, in particular in the shape of a rectangle.

6. A process according to any of claims 2 to 5, **characterized by** the use of a carrier material configured in the shape of a lamina in which the spinning holes are realized, with the lamina being inserted in holes, in particular stepped bores, of a support plate.

7. A process according to any of claims 2 to 5, **characterized by** the use of a carrier material configured in the shape of a deep-drawn spinning insert.

8. A process according to any of claims 2 to 5, **characterized by** the use of a carrier material which is flush with and welded into a nozzle body.

9. A process according to any of claims 2 to 8, **characterized by** the use of a spinneret in which more than 1000, preferably more than 10000, spinning holes are provided.

10. A process according to any of claims 2 to 9, **characterized by** the use of spinning holes whose outlet diameters range from 50µm to 1000µm, preferably from 100µm to 500µm.

11. A process according to any of the previous claims, **characterized in that** the cellulose solution has a zero shear viscosity of at least 100 Pas at 90°C.

12. A process according to any of the previous claims, **characterized in that**, upon extrusion, the cellulose solution is conveyed via an air gap into a precipitation bath.

## Revendications

1. Procédé de production de corps moulés cellulosiques, dans lequel une solution de cellulose dans un oxyde d'amine tertiaire aqueux est extrudée sur un moule de formage qui présente un matériau de support et au moins une ouverture d'extrusion aménagée dans le matériau de support et à partir de la masse moulée extrudée, de façon en elle-même connue, le corps moulé cellulosique est obtenu par précipitation, **caractérisé en ce que** la masse pouvant être moulée est extrudée sur un moule de formage dans lequel au moins une ouverture d'extrusion a été produite par application d'énergie thermique au moyen de faisceaux d'électrons.

2. Procédé selon la revendication 1, **caractérisé par** l'utilisation d'une filière dotée d'ouvertures d'extrusion sous la forme d'une ou plusieurs trous de filage comme moule de formage.

3. Procédé selon la revendication 2, **caractérisé en ce que** le diamètre moyen de la section du courant extrudé par le trou de filage de la masse pouvant être moulée diminue progressivement.

4. Procédé selon la revendication 2 ou 3, **caractérisé par** l'utilisation d'un matériau de support de forme annulaire.

5. Procédé selon la revendication 2 ou 3, **caractérisé par** l'utilisation d'un matériau de support de forme rectangulaire, en particulier de forme carrée.

6. Procédé selon l'une des revendications 2 à 5, **caractérisé par** l'utilisation d'un matériau de support qui a la forme d'une plaquette dans laquelle les trous de filage sont aménagés, et dans lequel la plaquette est utilisée dans des trous, en particulier des alésages étagés d'une plaque de support.

7. Procédé selon l'une des revendications 2 à 5, **caractérisé par** l'utilisation d'un matériau de support se présentant sous la forme d'un insert de filage embouti.

8. Procédé selon l'une des revendications 2 à 5, **caractérisé par** l'utilisation d'un matériau de support qui est en plan avec un corps de filière et est soudé dans celui-ci.

9. Procédé selon l'une des revendications 2 à 8, **caractérisé par** l'utilisation d'une filière dans laquelle plus de 1000, de préférence, plus de 10000 trous de filage sont prévus.

10. Procédé selon l'une des revendications 2 à 9, **caractérisé par** l'utilisation de trous de filage, dans lequel le diamètre de sortie du trou se situe dans une plage de 50 µm à 1000 µm, de préférence, de 100 µm à 500 µm.

11. Procédé selon l'une des revendications précédentes, **caractérisé en ce que** la solution de cellulose présente une viscosité nulle (« Nullviskosität ») d'au moins 100 Pas à 90° C.

12. Procédé selon l'une des revendications précédentes, **caractérisé en ce que** la solution de cellulose est conduite après l'extrusion sur une couche d'air dans un bain de précipitation.
